# EUROPÄISCHE PATENTSCHRIFT

(11) **EP 2 729 228 B1**
(45) Veröffentlichungstag und Bekanntmachung des Hinweises auf die Patenterteilung: **26.12.2018**
(21) Anmeldenummer: 12737487.4
(22) Anmeldetag: 09.07.2012
(51) Int. Cl.: B01D 29/64, B01D 29/84, B01D 29/96, B01D 29/70, B01D 29/41

(54) **VERFAHREN ZUM TRENNEN VON FESTSTOFFEN UND FLÜSSIGKEITEN EINER SUSPENSION**
METHOD TO SEPARATE PARTICLES AND LIQUIDS FROM A SLURRY
PROCÉDÉ DE SEPARATION DE PARTICULES ET LIQUIDES D'UNE SUSPENSION

(30) Priorität: 09.07.2011 DE 102011107043
(43) Veröffentlichungstag der Anmeldung: 14.05.2014
(73) Patentinhaber: Brandolisio, Sergio, 41468 Neuss (DE)
(72) Erfinder: Brandolisio, Sergio, 41468 Neuss (DE)
(74) Vertreter: Rätsch, Caroline
(86) Internationale Anmeldenummer: PCT/EP2012/002881
(87) Internationale Veröffentlichungsnummer: WO 2013/007370

(56) Entgegenhaltungen:
- EP-A1- 2 189 205
- EP-A2- 0 138 188
- WO-A1-90/10489
- US-A- 3 360 869
- US-A- 4 081 381
- US-A- 4 293 411

## Beschreibung

Die Erfindung betrifft ein Verfahren zum Trennen von Feststoffen und Flüssigkeiten einer Suspension, wobei die Suspension in die Filtervorrichtung eingefüllt wird, die Suspension gefiltert wird und wobei der durch die Filterung der Suspension entstehende Filterkuchen gepresst wird. Es wird ferner eine Filtervorrichtung vorgeschlagen, die mindestens einen Filterhalter zur Aufnahme eines Filtermediums und mindestens eine Heizeinrichtung aufweist.

Filtervorrichtungen sind im Stand der Technik bestens bekannt. Sie werden beispielsweise in der Pharmaindustrie eingesetzt und dienen dazu, in Suspensionen enthaltene Feststoffe mittels des Filtermediums zu gewinnen. Die Feststoffe - beispielsweise Wirkstoffe eines Arzneimittels - können nach Trocknung und ggf. Reinigung als Vorprodukt weiterverarbeitet werden.

Eine bekannte Filtervorrichtung ist die so genannte Drucknutsche. Die Drucknutsche weist einen geschlossenen Behälter auf, in den die Suspension eingefüllt wird. Im unteren Bereich des Behälters ist das Filtermedium angeordnet. Die Suspension wird mit Druckluft oder z.B. Inertgasen durch das Filtermedium hindurchgepresst. Alternativ wird das Filtrat durch ein Vakuum abgesaugt. Oberhalb des Filtermediums verbleiben die Feststoffe - der so genannte Filterkuchen. Die Flüssigkeit - das Filtrat - wird unten aus der Drucknutsche abgeführt.

Nach der Filtration muss der Filterkuchen noch getrocknet werden. Hierzu weist die Drucknutsche einen Rührarm auf, dessen Rührkopf beheizt sein kann. Zusätzlich kann auch die Behälterwand mit einer Heizung versehen sein. Der Rührkopf rührt den Filterkuchen unter Zuführung von Wärme so lange, bis der Filterkuchen vollständig getrocknet ist. Dann wird der Filterkuchen aus der Drucknutsche ausgelassen oder entnommen.

Drucknutschen haben sich in der Industrie jahrzehntelang bestens bewährt. Es wurde allerdings gefunden, dass der Trocknungsprozess relativ lang dauert. Damit einher geht ein hoher Energiebedarf. Aus diesem Grund ist der Nutsche häufig ein Trockner nachgeschaltet.

Aus der EP 0 138 188 ist eine Filtervorrichtung bekannt, die einen drehbaren Arm aufweist. Am Ende des drehbaren Arms sind beheizbare Schaufeln angeordnet, die durch die Suspension hindurchgraben, um sie zu trocknen. Der Filterkuchen wird komplett durchgetrocknet, bevor er ausgetragen wird.

Aus der US 4, 081, 381 ist ebenfalls eine Filtervorrichtung bekannt, bei der der Filterkuchen thermisch getrocknet wird, bevor er ausgetragen wird.

Ausgehend von dem bekannten Stand der Technik liegt der Erfindung die **Aufgabe** zugrunde, ein Verfahren zu schaffen, das einerseits ein schnelleres Trocknen und andererseits eine Energiereduzierung ermöglicht.

Diese Aufgabe wird **gelöst** durch ein Verfahren mit den Merkmalen des Patentanspruchs 1.

Der Erfindung liegt die Erkenntnis zugrunde, dass der hohe Energiebedarf unter anderem darauf zurückzuführen ist, dass der gesamte Filterkuchen durchgerührt werden muss, bis er trocken ist. Dies bedeutet, dass auch bereits trockene Anteile des Filterkuchens wieder mit feuchten Anteilen vermengt werden, was insgesamt zu einer Verzögerung der Trocknung führt. Darüber hinaus sind dem Rührkopf größenmäßig Grenzen gesetzt. Damit ist auch die Heizfläche begrenzt.

Die Erfindung schlägt einen vollkommen anderen Weg der Trocknung ein. Zunächst wird - vorzugsweise mechanisch - der Filterkuchen gepresst. Anschließend wird lediglich die Oberfläche des Filterkuchens erwärmt, bis sie trocken ist. Nach deren Trocknung wird sie abgetragen. Dieser Prozess erfolgt vorteilhafterweise kontinuierlich, wie es im folgenden noch näher erläutert wird.

Durch die Pressung des Filterkuchens wird dem Filterkuchen Feuchtigkeit entzogen. Das erfindungsgemäße Verfahren bietet vorteilhaft die Möglichkeit, dass nach der Pressung - sofern gewünscht - eine Waschung des Filterkuchens durchgeführt werden kann. Hierdurch wird der Filterkuchen gereinigt. Anschließend kann der Filterkuchen wiederum gepresst werden. Gegenüber herkömmlichen Drucknutschen hat der Verfahrensschritt der Pressung den wesentlichen Vorteil, dass weniger Waschflüssigkeit benötigt wird, da durch die Pressung bereits wesentliche Teile der Verunreinigung entfernt werden.

Im Gegensatz zu der bekannten Nutschentrocknung wird nicht der gesamte Filterkuchen zunächst vollständig getrocknet und dann ausgetragen. Vielmehr wird erfindungsgemäß lediglich die Oberfläche thermisch getrocknet und dann abgetragen. Nach dem Abtragen der trockenen Oberfläche kann wiederum die nachfolgende (feuchte) Oberfläche getrocknet und anschließend abgetragen werden. Die Wärmeeinbringung erfolgt also gezielt lediglich im Oberflächenbereich des Filterkuchens, wodurch der Gesamtprozess deutlich energiearmer betrieben werden kann.

Unter dem Begriff der "Oberfläche" ist im Erfindungsgedanken nicht nur die unmittelbare Oberfläche zu verstehen, sondern eine Oberflächenschicht, die beispielsweise einige Millimeter betragen kann.

In wesentlicher Weiterbildung der Erfindung wird vorgeschlagen, dass der Filterkuchen während seiner Erwärmung gedreht wird. Eine Drehung - im Sinne einer Drehung zum Transportieren des Kuchens - gestattet es, dass das erfindungsgemäße Verfahren kontinuierlich betrieben wird. Mit fortschreitendem (Dreh-)Weg trocknet die Oberfläche des Kuchens zunehmend.

Vorteilhafterweise wird der Filterkuchen durch eine Heizungseinrichtung erwärmt bzw. getrocknet und der Filterkuchen relativ zu der Heizungseinrichtung gedreht. Bei einer konkreten Ausführungsform der Erfindung ist die Heizeinrichtung stationär angeordnet und der Kuchen wird entlang der Heizeinrichtung bewegt. Hierbei kann insbesondere vorgesehen sein, dass es zu einer Kontakttrocknung des Kuchens kommt. Der Kuchen berührt also vorzugsweise die Heizfläche der Heizeinrichtung. Dies führt zu einem besseren Wirkungsgrad der Energieeinbringung. Gleichwohl wird in der Praxis beim Betreiben der Filtervorrichtung sichergestellt, dass die Anpresskraft des Kuchens an die Heizfläche nicht zu stark ist, da nämlich sonst der Kuchen blockieren könnte.

Als Kern der Erfindung wird angesehen, dass lediglich die Oberflächenbereiche des Kuchens erwärmt und die dadurch getrockneten Oberflächenbereiche ("Oberfläche") abgetragen werden. Als besonders vorteilhaft hat es sich erwiesen, dass die getrocknete Oberfläche des Filterkuchens durch eine Relativbewegung zu einer Abtrageinrichtung abgetragen wird. Insbesondere kann vorgesehen sein, dass die Abtrageinrichtung stationär gehalten ist. Der Filterkuchen wird also an der Abtrageinrichtung vorbeibewegt. Dabei gelangt die Abtrageinrichtung in Eingriff mit der Oberfläche und trägt diese (zum Teil) ab. Danach kann sie aus der Filtervorrichtung ausgetragen werden.

Wie bereits zuvor ausgeführt, kann es sich bei der Bewegung des Filterkuchens insbesondere um eine Drehung des Filterkuchens handeln. Dadurch wird vorteilhaft ein kontinuierliches Verfahren geschaffen. In einem ersten Abschnitt wird die Oberfläche erwärmt. Mit zunehmender Drehung nimmt die Dicke der getrockneten Oberfläche(nschicht) zu. In einem zweiten Abschnitt ist die Abtrageinrichtung angeordnet. Hier wird die getrocknete Oberfläche abgetragen. Mit der Abtragung wird eine Schicht des Filterkuchens freigelegt, die noch nicht getrocknet ist. Sie gelangt mit weiterer Drehbewegung wiederum unter die Heizeinrichtung und wird nachfolgend getrocknet, bevor auch sie mit fortschreitender Drehung abgetragen wird.

In der Praxis kann der Fall auftreten, dass der Filterkuchen mit fortschreitender Trocknung härter wird. Gleiches gilt für die Oberfläche des Filterkuchens bei dem erfindungsgemäßen Verfahren. Insoweit wird es als besonders günstig angesehen, wenn die Oberfläche des Kuchens zunächst zumindest teilweise angeritzt und/oder aufgebrochen und/oder abgelöst wird, bevor sie abgetragen wird. Das Anritzen oder Aufbrechen kann durch eine Art Kamm oder Messer erfolgen, dessen Arbeitstiefe vorzugsweise einstellbar ist. Der Kamm bzw. das Messer dringt in die Oberfläche des Filterkuchens ein und löst oder ritzt diese an. Dadurch wird die Oberfläche entweder bereits teilweise abgelöst oder zumindest so parzelliert, dass sie im unmittelbar nachfolgenden Schritt abgetragen werden kann.

Wie bereits eingangs erwähnt, findet das erfindungsgemäße Verfahren insbesondere Anwendung in der Pharmazie. Hier (aber auch in anderen Bereichen) sind häufig sterile Umgebungsbedingungen erforderlich. Insoweit ist eine bevorzugte Ausführungsform der Erfindung dadurch gekennzeichnet, dass die Filterung, die Pressung des Filterkuchens, die Trocknung der Oberfläche und der Abtrag des Kuchens in einem geschlossenen Raum erfolgt. Der geschlossene Raum kann zum Austragen des Feststoffes geöffnet werden.

Es wird ferner eine Filtervorrichtung vorgeschlagen, mit mindestens einem Filterhalter zur Aufnahme eines Filtermediums und mit mindestens einer Heizeinrichtung. Die Filtervorrichtung zeichnet sich dadurch aus, dass der Filterhalter in Richtung auf die Heizeinrichtung bewegbar angeordnet ist.

Der Filterhalter trägt vorteilhaft des Filtermedium. Nach der Filtration setzt sich auf dem Filtermedium der Filterkuchen ab. Durch Bewegung des Filterhalters wird der Filterkuchen in Richtung auf die Heizeinrichtung bewegt. Zum einen kann dadurch vorteilhaft der Filterkuchen in einem ersten Schritt gepresst werden, um Restnässe mechanisch aus dem Filterkuchen zu entfernen. Zum anderen kann der Filterkuchen nahe an die Heizeinrichtung gebracht werden. Insbesondere wird eine Kontakttrocknung angestrebt. Dies bedeutet, dass sich der Kuchen zur Trocknung vorzugsweise nicht nur nahe an der Heizeinrichtung befindet, sondern die Heizfläche der Heizeinrichtung berührt. Dies gewährleistet einen guten Wärmeübergang und führt damit zur Energieeinsparung.

Die Filtervorrichtung weist einen weiteren Vorteil gegenüber herkömmlichen Filtervorrichtungen auf. Bei der eingangs diskutierten Drucknutsche ist konstruktionsbedingt ständig ein Totraum vorhanden, der nicht nutzbar ist. Ein derartiger Totraum bedingt Energieverluste. Erfindungsgemäß hingegen kann der Filterkuchen in Richtung auf die Heizeinrichtung bewegt und damit ein Totraum minimal gehalten oder - bei Kontakttrocknung - ausgeschlossen werden.

Vorzugsweise wird der Filterhalter durch Druckluft oder Gas angehoben.

In wesentlicher Weiterbildung der Filtervorrichtung wird vorgeschlagen, dass der Filterhalter relativ zu der Heizeinrichtung drehbar angeordnet ist. Wie bereits im Zusammenhang mit dem erfindungsgemäßen Verfahren erörtert, erfolgt durch die Drehung des Filterhalters entlang der Heizeinrichtung ein zunehmender Wärmeintrag in einen Oberflächenabschnitt. Mit fortschreitender Drehung wird der Oberflächenabschnitt also zunehmend getrocknet. Im Ergebnis wird eine Konstruktion geschaffen, die sowohl eine energieeffiziente Trocknung als auch eine kontinuierliche Trocknung und Abtragung des Kuchens ermöglicht.

Eine vorteilhafte Ausführungsform der Erfindung ist dadurch gekennzeichnet, dass der Filterhalter drehfest mit einer Welle verbunden und vorzugsweise ringförmig ausgebildet ist. Die Welle versetzt den Filterhalter in eine Drehbewegung. In der Praxis kann zur Bewegung des Filterhalters vorgesehen sein, dass der Filterhalter entweder auf der Welle verschiebbar angeordnet ist oder der Filterhalter mit der Welle fest verbunden und die Welle selbst in Längsrichtung verschiebbar angeordnet ist. Die ringförmige Ausgestaltung des Filterhalters gestattet es, dass das Filtermedium (zusammen mit dem Filterkuchen) gedreht wird und dass gleichzeitig ein ungenutzter Totraum minimal gehalten werden kann.

In jedem Fall ist es vorteilhaft, wenn der Filterkuchen zwischen dem Filterhalter (bzw. dem auf oder in dem Filterhalter aufgenommenen Filtermedium) und der Heizeinrichtung eingespannt werden kann. In diesem Zusammenhang wird in Weiterbildung der Konstruktion vorgeschlagen, dass die Heizeinrichtung und der Filterhalter so zueinander angeordnet sind, dass zwischen ihnen der sich bei der Filtration einer Suspension ergebende Filterkuchen angeordnet ist. Bei einer aufrecht stehenden Filtervorrichtung mit einem horizontal angeordneten Filterkuchen wird die Heizeinrichtung vorzugsweise über und die Filterhalterung vorzugsweise unter dem Filterkuchen angeordnet sein.

Es wurde vorstehend dargelegt, dass eine Drehung des Filterhalters und damit des Filterkuchens eine Reihe von Vorteilen aufweist. Die Drehung des Kuchens kann ferner dazu genutzt werden, auch die Oberfläche des Kuchens abzutragen. Hierzu kann zweckmäßig eine Abtrageinrichtung vorgesehen sein, zu der der Filterhalter relativ drehbar angeordnet ist.. Die Abtrageinrichtung ist vorteilhafterweise stationär gehalten. Der Filterkuchen bewegt sich also unter (oder ggf. über) der Abtrageinrichtung hinweg. Dabei greift die Abtrageinrichtung derart in die Oberfläche ein, dass die Oberfläche (d.h. eine oberflächennahe Schicht) abgetragen wird. Bei vorzugsweise kontinuierlicher Weiterdrehung des Filterkuchens wird die dadurch freigelegte neue Oberfläche erwärmt und dadurch getrocknet. Alternativ kann vorgesehen sein, dass der Filterhalter stationär gehalten und die Abtrageinrichtung bewegt wird. Im Übrigen ist eine relative Drehbewegung zwar beispielsweise in Hinblick auf den Platzbedarf der Filtervorrichtung und die Kontinuität des Abtragsvorgangs besonders vorteilhaft, grundsätzlich ist aber auch eine lineare Relativbewegung zwischen der Abtrageinrichtung und dem Filterhalter denkbar. Insoweit wird es als grundsätzlich vorteilhaft angesehen, wenn die Abtrageinrichtung und der Filterhalter relativ zueinander bewegbar angeordnet sind.

Als Abtrageinrichtung hat sich eine schaberartige oder messerartige Abtrageinrichtung bewährt, die vorzugsweise höhenverstellbar ist. Durch die Höhenverstellung kann die Abtragtiefe eingestellt werden. Die Einstellung wird man mit der Heizleistung der Heizeinrichtung und der Drehgeschwindigkeit des Filterhalters abstimmen.

Bei der Trocknung des Kuchens kann die Oberfläche des Kuchens erhärten. Unter Umständen reicht die Schabwirkung der Abtrageinrichtung nicht aus, um die Oberfläche tatsächlich vollständig zu entfernen. Aus diesem Grund kann zusätzlich eine Einrichtung zum Anritzen und/oder Aufbrechen und/oder Lösen der Oberfläche eines Filterkuchens vorgesehen sein, die die Oberfläche vorbearbeitet, indem sie die Oberfläche anritzt, aufbricht und/oder löst. Diese Einrichtung wird man in Drehrichtung des Filterhalters der Abtrageinrichtung vorschalten.

Die Konstruktion der Filtervorrichtung gestattet es, dass mehrere Filtervorrichtungen hintereinandergeschaltet werden. Hierdurch können größere Mengen an Suspension gefiltert werden mit dem besonders vorteilhaften Effekt, keine längere Trocknungszeiten in Kauf nehmen zu müssen. Eine besonders bevorzugte Ausführungsform ist dadurch gekennzeichnet, dass die Filtervorrichtungen auf einer gemeinsamen Antriebswelle sitzen, die vorteilhafterweise drehfest mit den Filtervorrichtungen verbunden sind.

Im Folgenden wird die Erfindung im Zusammenhang mit der anhängenden **Zeichnung** näher erläutert. Die Zeichnung zeigt in
- Figur 1: in schematischer Darstellung eine seitliche Schnittansicht durch ein erstes erfindungsgemäßes Ausführungsbeispiel einer Filtervorrichtung;
- Figur 2: in schematischer Darstellung eine seitliche Schnittansicht eines zweiten erfindungsgemäßen Ausführungsbeispiels einer Filtervorrichtung; und
- Figur 3: in schematischer Darstellung einen Querschnitt durch das Ausführungsbeispiel nach Figur 2.

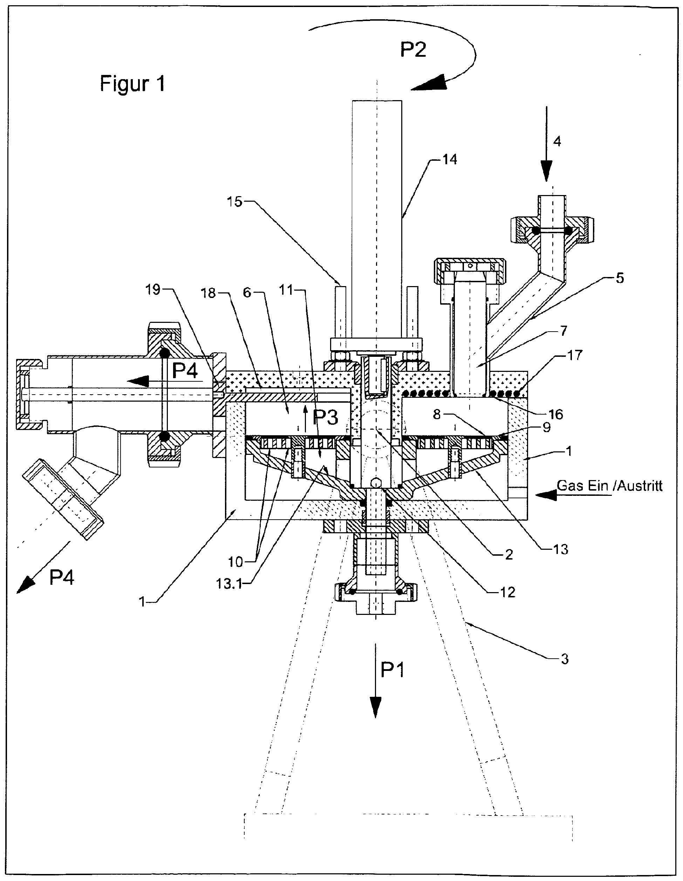

Figur 1 zeigt ein erstes Ausführungsbeispiel der zur Durchführung des erfindungsgemäßen Verfahrens bestimmten Filtervorrichtung in einer Schnittansicht. Die Filtervorrichtung weist ein Gehäuse 1 auf, das mitsamt allen Auf-, Ein- und Anbauten, wie sie im folgenden noch näher erläutert werden, um eine Achse 2 eines strich-liniert angedeuteten Gestells 3 schwenkbar ist.

Die Filtervorrichtung weist einen Einlass 4 auf, durch den die zu filternde Suspension in die Filtervorrichtung eingefüllt wird. Die (nicht gezeigte) Suspension gelangt über einen Stutzen 5 in einen Suspensionsraum 6. Der Suspensionsraum 6 ist ringförmig ausgebildet und durch einen Verschluss 7 verschließbar. Der Verschluss 7 ist als Kolben ausgebildet, kann aber auch anderweitig ausgestaltet sein.

Mit dem Bezugszeichen 8 ist ein Filtermedium gekennzeichnet. Das Filtermedium trennt die Feststoffe aus der Suspension heraus. Es entsteht der so genannte Filterkuchen. Das Filtermedium 8 wird dem Bedarfsfall angepasst. So kann es sich beispielsweise um ein Tuch oder ein Metallgewebe handeln.

Das Filtermedium 8 ist auf einem ringförmigen Einsatz 9 angeordnet. Damit das Filtrat, also die flüssige Komponente der Suspension, durch das Filtermedium 8 und den Einsatz 9 hindurchfließen kann, sind in dem Einsatz Öffnungen 10 ausgebildet. Durch diese Öffnungen 10 gelangt das Filtrat in einen Filtratraum 11 und wird von dort über Öffnungen 12 aus der Filtervorrichtung ausgelassen, wie es mit dem Pfeil P1 angedeutet ist.

Der Einsatz 9 ist an einer Trägereinrichtung 13 befestigt, die ihrerseits drehfest mit einer Antriebswelle 14 verbunden ist. Die Welle 14 ist in Richtung des Pfeils P2 drehbar.

Die Trägereinrichtung 13 weist einen Boden 13.1 für das Filtrat auf, der konisch ausgebildet ist. Das Filtrat läuft auf dem Boden 13.1 ab. Hierzu verjüngt sich der Boden 13.1 vorzugsweise zur Welle 14 hin. Das Filtrat fließt also zur Welle 14 hin ab und wird dort über die Öffnungen 12 ausgelassen. Alternativ sind Konstruktionen denkbar, bei denen das Filtrat nach außen abfließt.

Der Einsatz 9 und die Trägereinrichtung 13 werden zusammen als Filterhalter verstanden. Es versteht sich, dass zu dem Filterhalter weitere Konstruktionsteile, zum Beispiel Befestigungselemente für das Filtermedium, hinzukommen können. Es versteht sich ferner, dass der Filterhalter auch einteilig ausgebildet sein kann. Wesentlich ist bei dem gezeigten Ausführungsbeispiel, dass der Filterhalter - und damit das Filtermedium und damit der Filterkuchen - in Axialrichtung der Welle 14 verschiebbar angeordnet ist. Bei dem dargestellten Ausführungsbeispiel kann die Trägereinrichtung 13 zusammen mit der Welle 14 in Axialrichtung bewegt werden. Hierbei hebt sich die Welle 14 an und wird dabei über Führungen 15 geführt. In der Welle 14 (bzw. der Verlängerung der Welle 14) sind die erwähnten Öffnungen 12 ausgebildet, durch die das Filtrat abgeführt wird.

Die Bewegung des Filterhalters erfolgt zweckmäßig beispielsweise über Druckluft oder Gas. Hierzu weist das Gehäuse 1 einen Einlass auf, wie es in Figur 1 durch den Pfeil "Gas Ein/Austritt" gekennzeichnet ist.

Nach der Befüllung des Suspensionsraums 6 mit der Suspension wird der durch das Abfließen des Filtrats sich auf dem Filtermedium 8 ablagernde Filterkuchen zunächst gepresst, um durch die Pressung mechanisch den Kuchen weiter zu trocknen. Hierzu wird die Trägereinrichtung 13 nach oben in Richtung des Pfeils P3 bewegt. Dadurch wird der Filterkuchen gegen die obere Innenwand 16 des Gehäuses 1 gepresst, wodurch wiederum weitere Flüssigkeit (Filtrat) aus dem Kuchen entweicht.

Nach dem Pressvorgang kann der Filterkuchen gewaschen werden, sofern gewünscht. Die Waschflüssigkeit wird man über den Einlass 4 oder einen gesonderten (nicht dargestellten) Zulauf für die Waschflüssigkeit zuführen.

Ziel bei der Filtration ist die Trennung von Feststoffen (Filterkuchen) und Flüssigkeit (Filtrat). Letztere ist in der Praxis häufig als Trägerflüssigkeit ausgebildet. Die Feststoffe müssen für die weitere Verarbeitung des (Vor-)Produktes getrocknet sein. Insoweit kommt der Trocknung eine besondere Bedeutung zu.

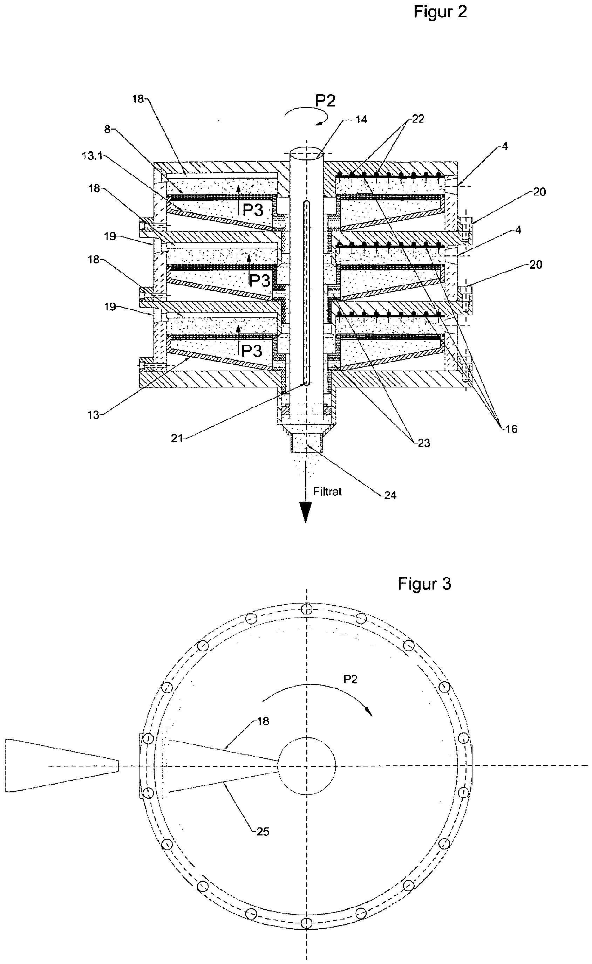

Die Innenwand 16 ist durch eine Heizeinrichtung 17 beheizt. Die Heizeinrichtung 17 ist in Figur 1 lediglich angedeutet. Sie kann z.B. zwei Elektroden aufweisen, die in die Gehäusewand eingelassen sind. Im Rahmen des Erfindungsgedankens liegt es, mehrere Elektroden (oder auch nur eine Elektrode) vorzusehen. Es sind auch alternative Heizeinrichtungen denkbar, beispielsweise mit Öl oder Wasser befüllte Heizschlangen, wie sie in den Figuren 1 und 2 angedeutet sind.

Die Heizeinrichtung sorgt dafür, dass die obere Innenwand 16 des Gehäuses 1 beheizt wird.

Nach der mechanischen Trocknung und ggf. Waschung des Filterkuchens wird der Filterkuchen in Kontakt mit der beheizten Innenwand 16 gebracht. Es findet eine Kontakttrocknung statt. Gleichzeitig wird die Antriebswelle in Richtung des Pfeils P2 gedreht, so dass der Filterkuchen an der durch die Heizeinrichtung 17 beheizten Innenwand 16 entlanggeführt wird. Hierdurch wird die Oberfläche des Filterkuchens erwärmt und getrocknet.

Mit dem Bezugszeichen 18 ist eine Abtrageinrichtung gekennzeichnet. Hierbei kann es sich um ein Messer, einen Schaber oder dergleichen handeln, der die getrocknete Oberfläche des Kuchens abträgt. Die Abtrageinrichtung 18 wird in den Figuren 2 und 3 noch näher erläutert.

Der getrocknete Filterkuchen, genauer gesagt der getrocknete Feststoff, wird, nachdem er getrocknet und durch die Abtrageinrichtung 18 abgetragen ist, aus der Filtervorrichtung ausgetragen. Hierzu weist die Filtervorrichtung eine Schließeinrichtung 19 auf, mit der der Suspensionsraum 6 verschlossen und in Richtung des Pfeils P3 geöffnet werden kann. Schließlich gelangt der Feststoff in Richtung des Pfeils P4 aus der Filtervorrichtung und kann dort beispielsweise durch einen Behälter oder dergleichen aufgefangen werden. Für den Austrag kann die Filtervorrichtung um die Achse 2 geschwenkt werden.

Es wird auf Figur 2 Bezug genommen. In Figur 2 sind mehrere Filtervorrichtungen zu einer Filtervorrichtungsanordnung zusammenfasst. Bei dem dargestellten Ausführungsbeispiel handelt es sich um 3 Filtervorrichtungen, die miteinander über Schraubverbindungen 20 gekoppelt sind. Der Aufbau der einzelnen Filtervorrichtungen stimmt grundsätzlich mit der Filtervorrichtung nach Figur 1 überein. Insbesondere weisen die Filtervorrichtungen jeweils ein Filtermedium 8 auf, das auf einer Trägereinrichtung 13 aufgebracht ist. Die Trägereinrichtung 13 ist jeweils drehfest mit der Welle 14 verbunden, wie es durch die Feder-Nut-Verbindung 21 angedeutet ist. In diesem Zusammenhang sei darauf hingewiesen, dass entweder in der Welle 14 mindestens eine Nut ausgebildet sein kann, in die die Trägereinrichtungen 13 jeweils mit einer Feder eingreifen. Alternativ und vorzugsweise bildet die Welle 14 mindestens eine Feder, über die dann die Trägereinrichtungen 13 mit jeweiligen Nuten gestülpt werden und damit in einer drehfesten formschlüssigen Verbindung stehen. Gleichzeitig sind die Trägereinrichtungen 13 in Richtung des Pfeils P3 bewegbar, damit sie den Kuchen gegen die obere Innenwand 16 der jeweiligen Filtervorrichtung pressen können.

Die Heizeinrichtung in Figur 2 wird durch eine Heizschlange 22 gebildet, die mit Öl oder Wasser gespeist ist. Die Heizeinrichtung erstreckt sich mindestens über einen Großteil der Gehäusefläche.

Die Suspension wird jeweils durch den Einlass 4 eingelassen, der in Figur 2 lediglich angedeutet ist. Das Filtrat wird durch Öffnungen 23 und eine Hauptöffnung 24 aus der Filtervorrichtungsanordnung abgelassen.

Figur 3 zeigt in schematischer Darstellung einen Schnitt durch die Filtervorrichtungsanordnung nach Figur 2. Hier ist insbesondere die Anordnung der Abtrageinrichtung 18 zu sehen. Der Kuchen wird in Richtung des Pfeils 2 gedreht. Dabei wird dessen Oberfläche ständig erhitzt. Gelangt nun der Kuchen an die Abtrageinrichtung 18, wird die Oberfläche abgetragen. Hierzu kann die Filtervorrichtung um die Achse 2 (siehe Figur 1) gekippt werden.

In Drehrichtung des Pfeils 2 vorgeschaltet ist eine Einrichtung 25 zum Anritzen und/oder Aufbrechen und/oder Lösen der Oberfläche. Sie kann messer- oder kammartig ausgebildet sein und soll die Oberfläche des Kuchens anlösen, damit sie besser abgetragen werden kann.

### Bezugszeichenliste

- 1: Gehäuse
- 2: Achse
- 3: Gestell
- 4: Einlass
- 5: Stutzen
- 6: Suspensionsraum
- 7: Verschluss
- 8: Filtermedium
- 9: Einsatz
- 10: Öffnungen
- 11: Filtratraum
- 12: Öffnung
- 13: Trägereinrichtung
- 13.1: Boden
- 14: Welle
- 15: Führung
- 16: Innenwand
- 17: Heizeinrichtung
- 18: Abtrageinrichtung
- 19: Schließeinrichtung
- 20: Schraubverbindung
- 21: Feder-Nut-Verbindung
- 22: Heizschlange
- 23: Öffnung
- 24: Auslass
- 25: Einrichtung zum Anritzen / Aufbrechen / Lösen

## Patentansprüche

1. Verfahren zum Trennen von Feststoffen und Flüssigkeiten einer Suspension, wobei
- die Suspension in die Filtervorrichtung eingefüllt wird,
- die Suspension gefiltert wird, und wobei
- der durch die Filterung der Suspension entstehende Filterkuchen gepresst wird,
**dadurch gekennzeichnet,**
- **dass** lediglich die Oberfläche des Filterkuchens thermisch getrocknet wird und
- **dass** die getrocknete Oberfläche des Filterkuchens abgetragen wird.

2. Verfahren nach Anspruch 1, **dadurch gekennzeichnet, dass** der Filterkuchen während seiner thermischen Trocknung gedreht wird.

3. Verfahren nach Anspruch 1 oder 2, **dadurch gekennzeichnet,**
- **dass** der Filterkuchen durch eine Heizungseinrichtung erwärmt wird und
- **dass** der Filterkuchen relativ zu der Heizungseinrichtung gedreht wird.

4. Verfahren nach einem der Ansprüche 1 bis 3, **dadurch gekennzeichnet, dass** der Filterkuchen durch eine Relativbewegung zu einer Abtrageinrichtung abgetragen wird.

5. Verfahren nach Anspruch 4, **dadurch gekennzeichnet, dass** die Abtrageinrichtung stationär gehalten wird.

6. Verfahren nach einem der Ansprüche 1 bis 5, **dadurch gekennzeichnet,**
- **dass** die Oberfläche des Kuchens zunächst zumindest teilweise angeritzt und/oder aufgebrochen und/oder abgelöst wird, bevor sie abgetragen wird.

7. Verfahren nach einem der Ansprüche 1 bis 6, **dadurch gekennzeichnet, dass** die Filterung, die Pressung des Filterkuchens, die Trocknung der Oberfläche und der Abtrag des Kuchens in einem geschlossenen Raum erfolgt.

## Claims

1. Method for separating solids and liquids of a suspension, wherein
- the suspension is introduced into the filter device,
- the suspension is filtered, and wherein
- the filter cake formed by the filtering of the suspension is pressed,
**characterized**
- **in that** only the surface of the filter cake is dried thermally, and
- **in that** the dried surface of the filter cake is removed.

2. Method according to Claim 1, **characterized in that** the filter cake is rotated while it is being thermally dried.

3. Method according to Claim 1 or 2, **characterized**
- **in that** the filter cake is heated by a heating device, and
- **in that** the filter cake is rotated relative to the heating device.

4. Method according to one of Claims 1 to 3, **characterized in that** the removal process for the filter cake is realized by way of a relative movement with respect to a removal device.

5. Method according to Claim 4, **characterized in that** the removal device is held in a stationary manner.

6. Method according to one of Claims 1 to 5, **characterized**
- **in that** the surface of the cake is initially at least partially scored and/or broken up and/or detached before it is removed.

7. Method according to one of Claims 1 to 6, **characterized in that** the filtering, the pressing of the filter cake, the drying of the surface and the removal process for the cake are realized in a closed space.

## Revendications

1. Procédé de séparation de particules et de liquides d'une suspension,
- la suspension étant versée dans le dispositif de filtration,
- la suspension étant filtrée, et
- le gâteau de filtration résultant de la filtration de la suspension étant pressé,
**caractérisé en ce que**
- seule la surface du gâteau de filtration est séchée thermiquement et
- la surface séchée du gâteau de filtration est enlevée.

2. Procédé selon la revendication 1, **caractérisé en ce que**
le gâteau de filtration est mis en rotation pendant son séchage thermique.

3. Procédé selon la revendication 1 ou 2, **caractérisé en ce que**
- le gâteau de filtration est chauffé par un équipement de chauffage et
- le gâteau de filtration est mis en rotation relativement à l'équipement de chauffage.

4. Procédé selon l'une des revendications 1 à 3, **caractérisé en ce que** le gâteau de filtration est enlevé par un mouvement relatif par rapport à un équipement d'enlèvement.

5. Procédé selon la revendication 4, **caractérisé en ce que** l'équipement d'enlèvement est retenu de façon stationnaire.

6. Procédé selon l'une des revendications 1 à 5, **caractérisé en ce que**
- la surface du gâteau est d'abord au moins partiellement rayée et/ou cassée et/ou détachée avant d'être enlevée.

7. Procédé selon l'une des revendications 1 à 6, **caractérisé en ce que** la filtration, le pressage du gâteau de filtration, le séchage de la surface et l'enlèvement du gâteau s'effectuent dans un espace fermé.
